# EUROPEAN PATENT SPECIFICATION

(11) **EP 0 928 039 B1**
(45) Date of publication and mention of the grant of the patent: **23.08.2006**
(21) Application number: 98124880.0
(22) Date of filing: 30.12.1998
(51) Int. Cl.: H01P 1/208

(54) **Band elimination dielectric filter, dielectric duplexer and communication device using the same**
Dielektrisches Bandsperrfilter, dielektrischer Duplexer und Kommunikationsgerät damit
Filtre diélectrique coupe-bande, duplexeur diélectrique et appareil de communication les utilisant

(30) Priority: 05.01.1998 JP 30698; 25.02.1998 JP 4378498
(43) Date of publication of application: 07.07.1999
(73) Proprietor: MURATA MANUFACTURING CO., LTD., Nagaokakyo-shi Kyoto-fu 617-8555 (JP)
(72) Inventor: Kubota, Kazuhiko c/o Murata Manufacturing Co., Ltd, Nagaokakyo-shi, Kyoto-fu 617-8555 (JP); Ise, Tomoyuki c/o Murata Manufacturing Co., Ltd., Nagaokakyo-shi, Kyoto-fu 617-8555 (JP)
(74) Representative: Schoppe, Fritz

(56) References cited:
- EP-A- 0 496 512
- US-A- 4 727 342
- US-A- 5 373 270
- PATENT ABSTRACTS OF JAPAN vol. 97, no. 3, 31 March 1997 -& JP 08 293705 A (MURATA MFG CO LTD), 5 November 1996
- ISHIKAWA Y ET AL: "LOW PROFILE FILTER USING OPEN DISK DUAL MODE DIELECTRIC RESONATORS FOR MICROCELLULAR BASE STATION" PROCEEDINGS OF THE 25TH. EUROPEAN MICROWAVE CONFERENCE 1995, BOLOGNA, SEPT. 4 - 7, 1995, vol. 1, no. CONF. 25, 4 September 1995, pages 528-532, XP000740187 EUROPEAN MICROWAVE CONFERENCE COMMITTEE

## Description

The present invention relates to a band elimination dielectric filter, a dielectric duplexer, and a communication device for use in a mobile communication system for example.

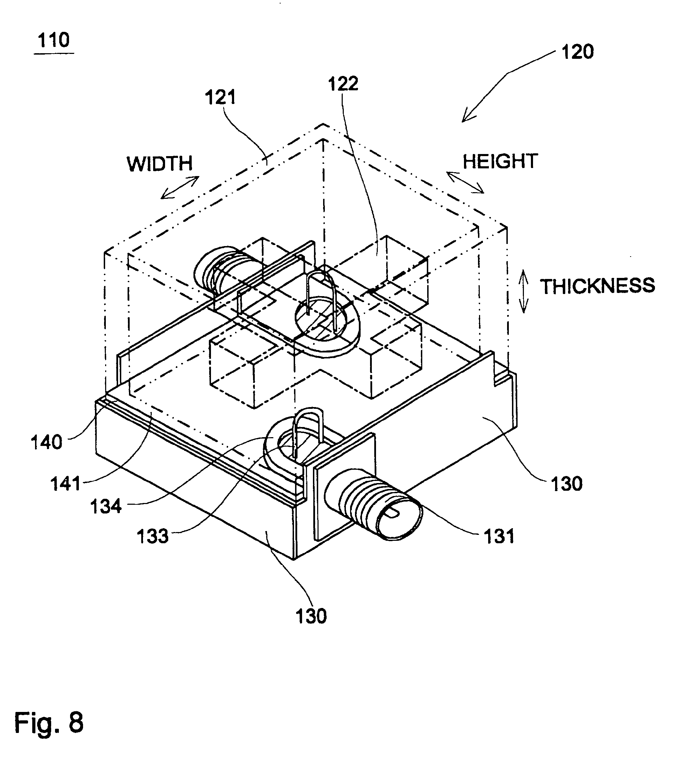

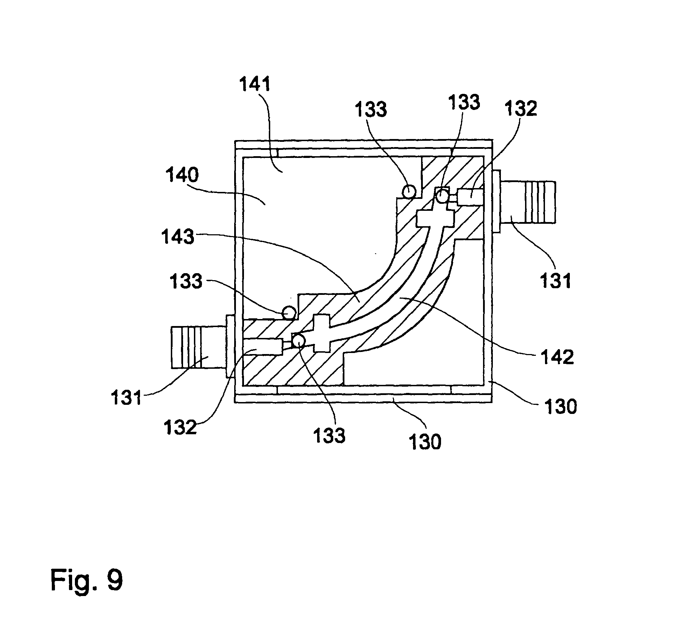

A conventional band elimination dielectric filter is described referring to FIG. 8 and FIG. 9.

FIG. 8 is a perspective view of a conventional band elimination dielectric filter 110, and FIG. 9 is a bottom plan view. The band elimination dielectric filter 110 comprises a dielectric resonator 120 consisting of ceramic in which two dielectric columns 122 are arranged in an intersecting manner in a cavity 121 having a conductive layer, a metallic case 130 and a base plate 140. A shield cavity comprises the metallic case 130 and the conductive cavity 121.

The metallic case 130 comprises an upper case and a lower case, but the upper case is not indicated in the figure to illustrate the inner structure in FIG. 8. An external connector 131 is for inputting/outputting the signal to/from the outside is mounted on the lower case 130. The base plate 140 is formed by providing a copper film 141 on each surface of an insulated base plate, and a strip line 142 is formed by etching a part thereof. The strip line 142 functions as a λ/4 wavelength line, and each end thereof is connected to an internal conductor 132 of the external connector 131. In the base plate 140, the strip line 142 is arranged opposite to the lower case 130 on the upper surface side of the lower case 130 so that the strip line 142 is not brought into direct contact with the lower case 130.

One end of a loop 133 for external coupling as an external coupling means is connected to the strip line 142. The loop 133 for external coupling is extended from the base plate 140 upwardly and approximately in the perpendicular direction, while the other end of loop 133 for external coupling is connected to an etching part 143 below the base plate 140 and a copper film 141 (earth part) other than the strip line 142. Above the base plate 140, the copper film 141 in the vicinity of a penetration part of the loop 133 for external coupling is removed, and an earth plate 134 having a hole of approximately same size as that of the removed part is arranged on the base plate 140. The earth plate 134 is mounted on an inner side surface of the lower case 130, and electrically connected thereto.

In such a band elimination dielectric filter 110, the signal inputted from one external connector 131 flows in two loops 133 for external coupling and the strip line 142. The loops 133 for external coupling generate the magnetic field respectively, and the corresponding loop 133 for external coupling is respectively magnetically coupled with the dielectric column 122. Then, the signal except the frequency corresponding to the dielectric column 122 is outputted from the external connector on the output side. The band elimination dielectric filter 110 thus functions as the two-stage band elimination dielectric filter to stop the resonance frequency band specified by the size of the dielectric column 122.

The resonance frequency and the non loaded Q of the dielectric resonator are determined by the size of the cavity and the dielectric column. When the distance in the transverse direction viewed from an opening side of the dielectric resonator is defined as the "width", the distance in the distal direction is defined as the "thickness", and the distance between the contact surfaces of the cavity and the dielectric column is defined as the "height", the following relationship is obtained.

For example, when the size of the cavity is left unchanged, and the width or the thickness of the dielectric column is increased, the resonance frequency is reduced. When the size of the dielectric column is left unchanged and the width of the cavity is increased, the resonance frequency is reduced. As for the relationship between the dielectric resonator and the non loaded Q, the non loaded Q is increased as the height of the dielectric column is increased.

As the height of the dielectric column is increased, the non loaded Q of the dielectric resonator is increased, but the cavity is also increased as the height of the dielectric column is increased. Thus, the conductive layer on the surface of the cavity is also increased in size, and the loss of the actual current flowing in the conductive layer is also increased. The loss corresponding thereto partly cancels the increase in the non loaded Q obtained by increasing the height of the dielectric column. Thus, in order to obtain the required non loaded Q, there is a concern that the dielectric resonator is increased in size.

From this reason, a band elimination dielectric filter free from any loss by the actual current flowing in the conductive layer on the surface of the cavity has been desired.

In a case of a two-stage band elimination dielectric filter using a TM double mode dielectric resonator in which two dielectric columns are arranged in an intersecting manner in the cavity, two dielectric columns of the same shape are formed according to the desired resonance frequency. When the non loaded Q of the dielectric resonator is increased, the height of the dielectric column is required to be large, and the cavity is also high accordingly. Increase in the cavity by increasing the height of one dielectric column means increase in the width of the cavity when viewed from the other dielectric column. As described above, when the width of the cavity is increased, the resonance frequency is reduced, and in order to obtain the prescribed resonance frequency, the width or the thickness of the dielectric column is reduced and the resonance frequency is required to be increased. There has been a concern that the resonance frequency and the non loaded Q can not be individually designed even in the two-stage band elimination dielectric filter.

US 4,727,342 describes a dielectric resonator incorporated into a dielectric base plate. The dielectric resonator comprises a pair of electrodes and a plurality of through-holes for electrically connecting the electrodes provided on the dielectric resonator. The filter system further comprises a micro-strip line, which is directly connected to the electrode or arranged close to the electrodes.

EP 0 496 512 describes a hybrid dielectric resonator having a high temperature super-conductor filter provided on a surface of the resonator. The resonator comprises cylindrical plugs, which are positioned in a conductive housing. The super-conductive layer can comprise a first and second layer, wherein a first layer underlies the resonator and a second layer overlies the resonator. For coupling electrical signals into the resonator, coupling probes are provided, extending from an input port into the conductive housing, wherein the resonator is provided.

US 5,373,270 describes a multi-cavity dielectric filter having an input connector and an output connector, which are coupled by a centre conductor. The filter comprises coupling loops which are arranged spaced from each other and are coupled to the centre conductor and the inside wall of the resonator housing. A plurality of resonators, each of which is associated with a respective coupling loop, are arranged close to the coupling loops in order to couple electrical signals from the centre contactor to the resonators.

JP 08293705 describes a thin-film laminated electrode comprising a plurality of thin-film conductors alternately laminated with thin-film dielectrics.

It is the object of the present application to provide a low loss band elimination dielectric filter wherein the degree of couling can be easily regulated.

It is an object of the present invention to provide a band elimination dielectric filter, a band elimination dielectric duplexer and a communication device in which the loss to be generated by the actual current flowing in the conductive layer of the cavity is eliminated, the non loaded Q is high, the height is reduced and wherein the subordination of the resonance frequency and the non loaded Q to each other is weakened, and the resonance frequency and the non loaded Q can be individually designed.

This object is achieved by a band elimination dielectric filter according to claim 1, a dielectric duplexer according to claim 5 and a communication device according to claim 6.

To achieve the above-mentioned objects, the band elimination dielectric filter of the present invention includes a conductive shield cavity, a dielectric resonator which is arranged in the shield cavity and provided with electrodes formed on two surfaces opposite to each other, and an external coupling means which is arranged in the shield cavity and connected to the dielectric resonator.

The actual current flowing in the conductive layer on the surface of the cavity of the dielectric resonator is eliminated by the conventional band elimination dielectric filter, and the loss at the band elimination dielectric filter is eliminated. The corresponding non loaded Q is not canceled, the dielectric resonator need not be so high, and the height of the dielectric resonator can be reduced.

In a band elimination dielectric filter according to a second aspect of the invention, the dielectric resonator is continuously arranged in the shield cavity.

Because the actual current flowing in the conductive layer on the surface of the cavity of the dielectric resonator is eliminated and the height is reduced compared with the conventional band elimination dielectric filter, the band elimination dielectric filter can be reduced in area.

In a band elimination dielectric filter according to a fourth aspect of the invention, at least one of electrodes formed on two surfaces opposite to each other of the dielectric resonator is formed by a thin film multilayer electrode.

The non loaded Q is further improved thereby.

A dielectric duplexer according to a fifth aspect of the invention includes at least two dielectric filters, a means for input/output connection to be connected to the respective dielectric filters, and a means for antenna connection to be commonly connected to the dielectric filter, and at least one of the dielectric filters is the band elimination dielectric filter according to first through fourth aspects of the invention.

A dielectric duplexer whose height is reduced, and whose loss is small can be provided thereby.

A communication device according to a sixth aspect of the invention includes a dielectric duplexer according to a fifth aspects of the invention, a circuit for transmission to be connected to at least one means for input/output connection of the dielectric duplexer, a circuit for reception to be connected to at least one means for input/output connection different from the means for input/output connection to be connected to the circuit for transmission, and an antenna to be connected to a means for antenna connection of the dielectric duplexer.

A communication device whose height is reduced and whose loss is small can be provided thereby.
FIG. 1 is an exploded perspective view of a band elimination dielectric filter of the present invention;
FIG. 2 is an exploded perspective view of a band elimination dielectric filter in a second embodiment of the present invention;
FIG. 3 is a sectional view taken along the line X-X of FIG. 2;
FIG. 4 is an exploded perspective view of a band elimination dielectric filter in a third embodiment of the present invention;
FIG. 5 is a sectional view taken along the line Y-Y of FIG. 4;
FIG. 6 is an exploded perspective view of a dielectric duplexer in a fourth embodiment of the present invention;
FIG. 7 is a schematic diagram of a communication device of the present invention;
FIG. 8 is a schematic perspective view of a conventional band elimination dielectric filter; and
FIG. 9 is a bottom plan view of a conventional band elimination dielectric filter.

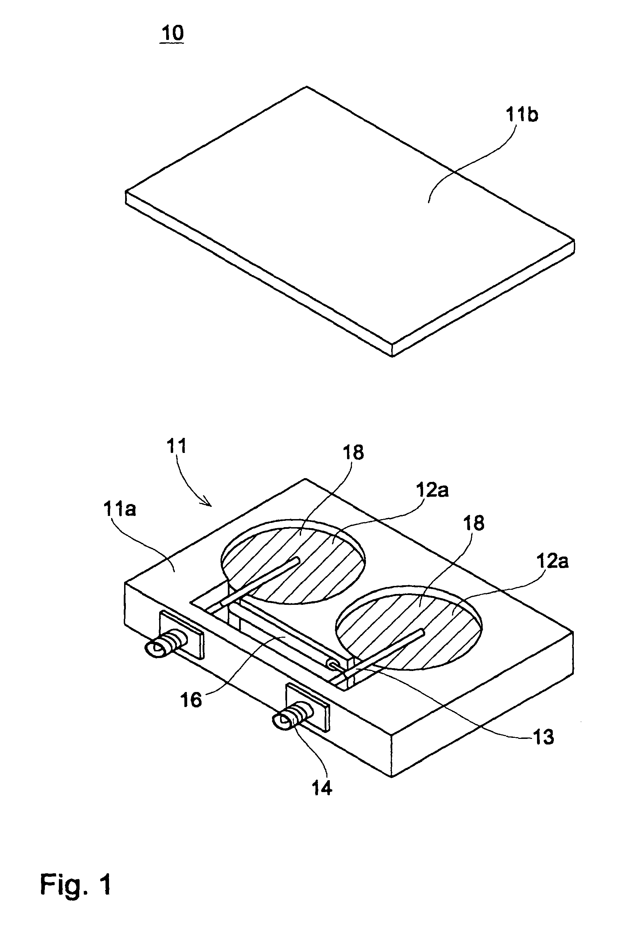

An embodiment of a band elimination dielectric filter of the present invention is described referring to FIG. 1. FIG. 1 is an exploded perspective view where a lid part 11b of a shield cavity 11 of a band elimination dielectric filter 10 is opened to illustrate the internal condition.

The band elimination dielectric filter 10 comprises the shield cavity 11 formed of a metal such as iron, a dielectric resonator 12a having electrodes 18 on two surfaces opposite to each other, an external coupling means 13, and an external connector 14 for input/output to be mounted on the shield cavity 11. That is, in the present embodiment, the two-stage band elimination dielectric filter 10 is constructed so that two dielectric resonators 12a are continuously arranged in the body 11a of the shield cavity 11 and the external connector 14 for input/output is conducted through a λ/4 wavelength line 16.

The dielectric resonator 12a is formed of the ceramic in a columnar shape, and electrodes 18 are formed on two surfaces opposite to each other through coating or baking of the silver paste. One electrode surface of the dielectric resonator 12a is connected and fixed to an inner bottom surface of the body 11a of the shield cavity 11 by a means such as soldering. The reliability on the temperature change is improved if the electrode surface is soldered to a metallic earth plate of the alloy of iron and nickel, and then, stored in the shield cavity 11, and the coefficient of linear expansion of the earth plate is similar to that of the dielectric resonator 12a though the arrangement is not indicated in the figure. In this embodiment, the dielectric resonator 12a is columnar in shape, but the effect on the characteristic such as the increase in the non loaded Q can be demonstrated compared with the conventional band elimination dielectric filter though the shape is prismatic or any other shape. However, the distance from the center to the edge is not constant on two surfaces opposite to each other on which the electrodes are formed in the prismatic dielectric resonator. Thus, the electric potential difference is generated at the edge of the electrodes, and the current flows therein. Because the current flows and the loss is generated thereby, the columnar dielectric resonator is desirable from the characteristic aspect of the band elimination dielectric filter.

The external coupling means 13 is formed of a metallic wire, and connected to a center conductor of the external connector 14 at one end with the solder. The external coupling means 13 is arranged so as to be extended in the space between the dielectric resonator 12a and the shield cavity 11, and the electrode 18 of the dielectric resonator 12a is separated from the shield cavity 11 with an interval therebetween, and is not electrically connected thereto.

The signal inputted from the external connector 14 flows from the external connector 14 to the external coupling means 13 to generate the capacitance between the external coupling means 13 and the dielectric resonator 12a. The external coupling means 13 is connected to the dielectric resonator 12a with the capacitance, and resonance is achieved at the resonance frequency to be specified by the area at the section parallel to the electrodes 18 of the dielectric resonator 12a. The degree of coupling of the external coupling means 13 with the dielectric resonator 12a is determined by the area opposite to each other or the distance therebetween, and the degree of coupling becomes stronger as the area is larger, or as the distance is shorter. Thus, the degree of coupling can be regulated by changing the length of the external coupling means 13 and the place of arrangement. The dielectric filter to stop the wide band can be realized by increasing the degree of coupling, and the dielectric filter to stop the narrow band can be realized by decreasing the degree of coupling. Direct connection of the external coupling means 13 to the dielectric resonator 12a maximizes the coupling to obtain the dielectric filter to stop the wide band.

Then, the function of the dielectric filter 10 of the present embodiment is described. The signal to be inputted from the external connector 14 generates the electric field between the electrodes 18 formed on two surfaces opposite to each other of the dielectric resonator 12a through the coupling of the external coupling means 13 with the dielectric resonator 12a. The magnetic field is generated along the circumference of the dielectric resonator 12a, and as a result of the concentrated electro-magnetic field within the dielectric resonator 12a, the distribution of the electro-magnetic field becomes similar to that in the TM₀₁₀ mode.

In such a construction, the actual current hardly flows in the shield cavity 11 in the band elimination dielectric filter 10 of the present invention. Thus, the loss generated by the flow of the actual current in the conductive layer (equivalent to the shield cavity) on the surface of the cavity of the dielectric resonator in the conventional band elimination dielectric filter can be eliminated. Similar to the fact that the non loaded Q of the conventional dielectric resonator has been specified by the height of the dielectric column, the non loaded Q in the present invention is also specified by the height of the dielectric resonator 12a. Because the loss is reduced in the present invention as described above, the height of the dielectric resonator 12a need not be so large, and the height of the band elimination dielectric filter 10 can be reduced compared with the conventional structure.

The resonance frequency is specified by the area of the dielectric resonator 12a at the section parallel to the electrodes 18, and the non loaded Q is mainly specified by the height of the dielectric resonator 12a, respectively, and the relationship to affect on each other is practically eliminated. Because the resonance frequency and the non loaded Q can be individually designed according to the desired values, the degree of freedom of the design is increased to facilitate the manufacture of the band elimination dielectric filter 10.

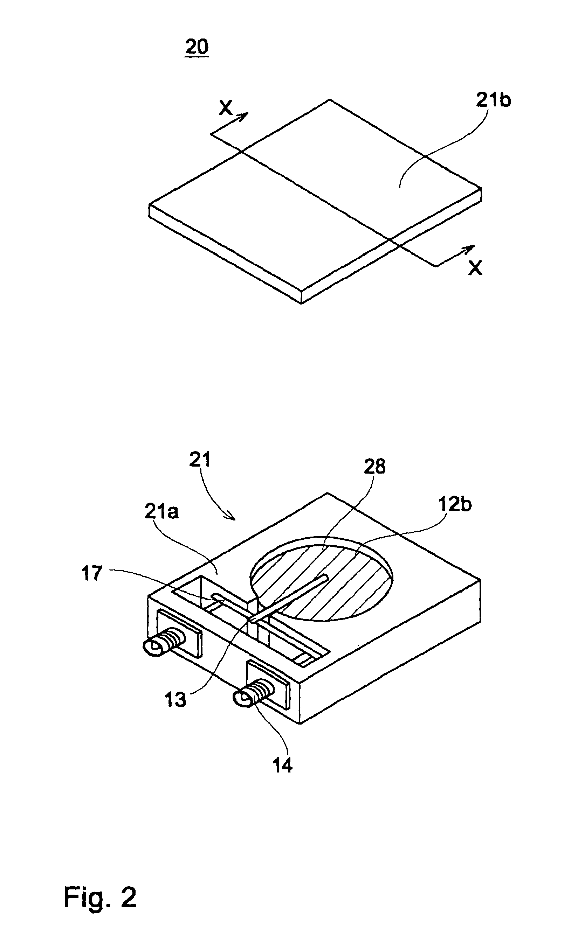

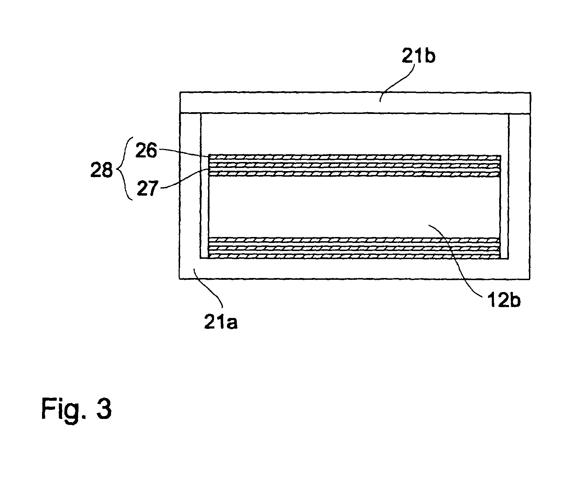

The second embodiment of the present invention is described referring to FIG. 2 and FIG. 3. FIG. 2 is an exploded perspective view where a lid part 21b of a shield cavity 21 of a band elimination dielectric filter 20 is opened to illustrate the internal condition similar to FIG. 1 to illustrate the first embodiment. In addition, FIG. 3 is a sectional view taken along the line X-X in FIG. 2. The same symbol is attached to the same part in the first embodiment, and the detailed description is omitted.

The band elimination dielectric filter 20 illustrated in FIG. 2 comprises a metallic shield cavity 21, a columnar dielectric resonator 12b in which a thin film multilayer electrode 28 is formed on two surfaces opposite to each other, and an external coupling means 13. External connectors 14 for input/output are mounted on a shield cavity 21, and the external connectors 14 are conducted to each other through a metallic wire 17.

The signal to be inputted from the external connector 14 flows from the metallic wire 17 connected to the center conductor of the external connector 14 with the solder to the external coupling means 13. The external coupling means 13 arranged so as to be extended in the space between the shield cavity 21 and the disconnected electrode side of the dielectric resonator 12b soldered to an inner bottom surface of a body 21a of the shield cavity 21, is coupled with the dielectric resonator 12b with the capacitance. The external coupling means is resonated at the resonance frequency specified by the area of the dielectric resonator 12b at the section parallel to the thin film multilayer electrode 28, and functions as the band elimination dielectric filter to stop the resonance frequency.

In this embodiment, as illustrated in the sectional view in FIG. 3, the thin film multilayer electrode 28 in which an electrode layer 26 and a dielectric layer 27 are alternately laminated on two surfaces opposite to each other of the dielectric resonator 12b. Use of the thin film multilayer 28 can reduce the loss at the electrode part. Thus, the non loaded Q is increased compared with the case where a single-layered silver electrode, etc., is used. As a result, the height of the band elimination dielectric filter can be further reduced with the same non loaded Q compared with the band elimination dielectric filter 10 in the first embodiment.

Needless to say, similar effect can be obtained by using the thin film multilayer electrode in the two-stage band elimination dielectric filter of the first embodiment.

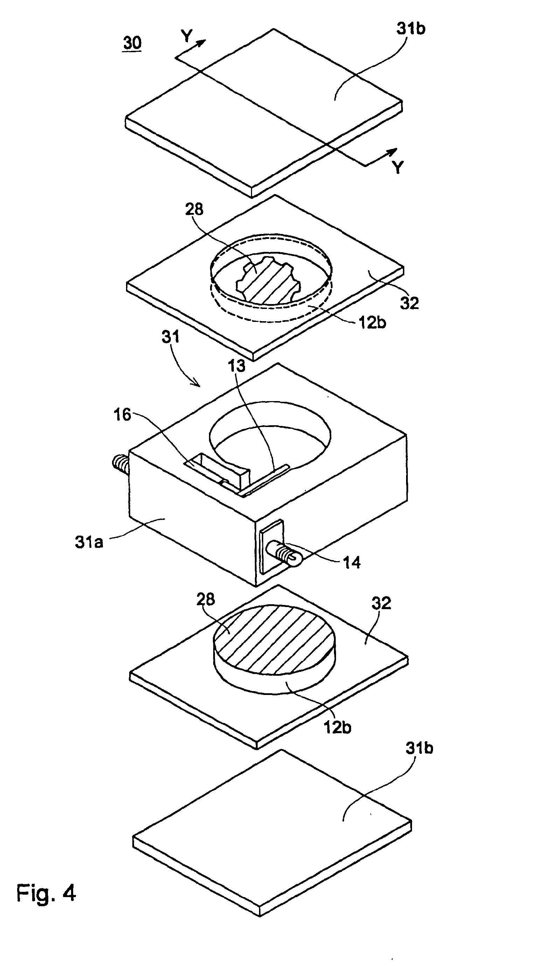

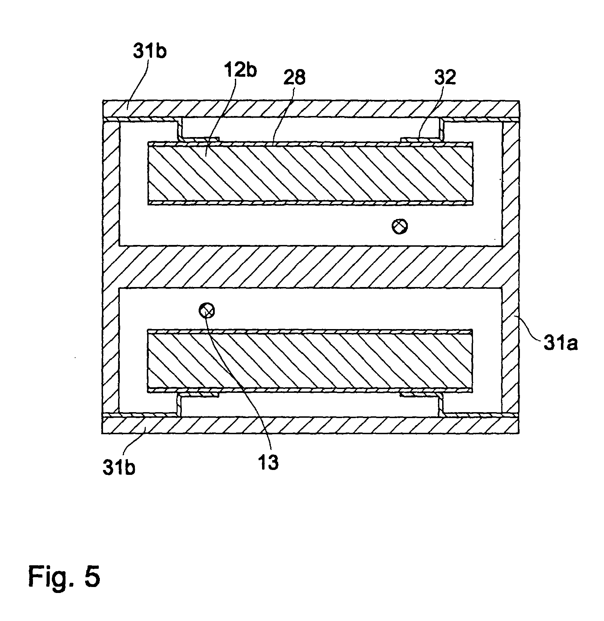

A band elimination dielectric filter of the third embodiment of the present invention is described referring to FIG. 4 and FIG. 5. FIG. 4 is an exploded perspective view of a band elimination dielectric filter of the present embodiment, and FIG. 5 is a sectional view taken along the line Y-Y in FIG. 4. The same symbol is attached to the same part in the first embodiment, and the detailed description is omitted.

As illustrated in FIGs 4 and 5, a band elimination dielectric filter 30 of the present embodiment comprises a shield cavity 31 in which an iron part is silver-plated and recessed parts are formed on a face side and a back side, a columnar dielectric resonator 12b in which a thin film multilayer electrode 28 is formed on two surfaces opposite to each other, an earth plate 32 in which a copper plate is silver-plated, an external coupling means 13 comprising a metallic wire, and external connectors 14 mounted on the shield cavity 31.

An earth plate 32 having a stepped part and a hole for soldering is soldered on one surface on which the thin film multilayer electrode 28 of the dielectric resonator 12b is formed. Because the earth plate 32 is held by a body 31a of the shield cavity 31 and a lid part 31b, the dielectric resonator 12b is arranged in the recessed parts on the face side and the back side of the shield cavity 31.

One end of the external coupling means 13 is connected to a center conductor of the external connector 14 mounted on the shield cavity 31, and extended between the shield cavity 31 and the dielectric resonator 12b. Further, the center conductors of the external connectors 14 are connected to each other through a λ/4 wavelength line 16.

In such a band elimination dielectric filter 30, the signal to be inputted from the external connector 14 flows from the external connector 14 to the external coupling means 13, and generates the capacitance between the external coupling means 13 and the dielectric resonator 12b. The external coupling means 13 is coupled with the dielectric resonator 12b with the capacitance, and the external coupling means is resonated at the resonance frequency specified by the area of the dielectric resonator 12b at the section parallel to the thin film multilayer electrode 28, and functions as the two-stage band elimination dielectric filter to stop the frequency band.

In such a band elimination dielectric filter 30 where the dielectric resonators 12b are laminated, the actual current hardly flows in the shield cavity 31, and the loss generated by the actual current flowing in the conductive layer (equivalent to the shield cavity) on the surface of the cavity of the dielectric resonator in the conventional band elimination dielectric filter can be eliminated. Thus, the height of the band elimination dielectric filter can be reduced compared with the conventional band elimination dielectric filter though the characteristics are similar. Further, the area can be reduced compared with the first embodiment, the band elimination dielectric filter in which the dielectric resonators are continuously arranged as illustrated in the first embodiment and the band elimination dielectric filter in which the dielectric resonators are put on top of each other can be selectively used according to the intended use.

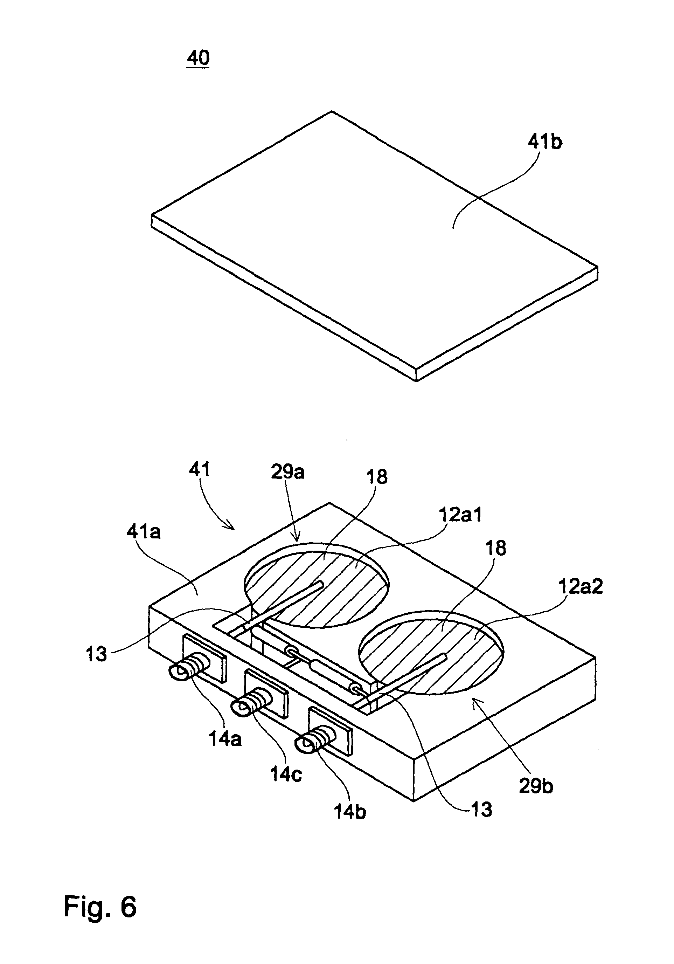

A fourth embodiment of the present invention is described referring to FIG. 6. FIG. 6 is an exploded perspective view in which a lid part 41b of a shield cavity 41 in a dielectric duplexer 40 is opened to illustrate the inner condition. The same symbol is attached to the same part of the above-mentioned embodiment, and the detailed description is omitted.

As illustrated in FIG. 6, the dielectric duplexer 40 of the present embodiment comprises a metallic shield cavity 41, two columnar dielectric resonators 12a1,12a2 provided with electrodes 18 formed on two surfaces opposite to each other and having different resonance frequencies, and an external coupling means 13. A dielectric filter part 29a for transmission comprises one dielectric resonator 12a1, and a dielectric filter part 29b for reception comprises the other dielectric resonator 12a2. An external connector 14a for connecting a transmission circuit, an external connector 14b for connecting a reception circuit, and an external connector 14c for connecting an antenna are mounted on the shield cavity 41, the external connector 14a for connecting the transmission circuit is connected to the dielectric filter part 29a for transmission, while the external connector 14b for the reception circuit is connected to the dielectric filter part 29b for reception. The external connector 14c for connecting the antenna is connected to both the dielectric filter part 29a for transmission and the dielectric filter part 29b for reception.

This dielectric duplexer 40 is resonated at the resonance frequency specified by the area of the electrodes 18 of the dielectric resonator 12a1 of the dielectric filter part 29a for transmission at the section parallel to the electrodes 18, and the resonance frequency is stopped. Similarly, the dielectric duplexer is resonated at the resonance frequency specified by the area of the dielectric resonator 12a2 of the dielectric filter part 29b for reception at the section parallel to the electrodes 18, and the resonance frequency is stopped. The dielectric duplexer functions to stop the respective bands in transmission and reception.

In the dielectric duplexer 40 of such a construction, the actual current hardly flows in the shield cavity 41, and the loss generated by the actual current flowing in the conductive layer (equivalent to the shield cavity) on the surface of the cavity of the dielectric resonator in the conventional dielectric duplexer can be eliminated. The height of the dielectric duplexer can be reduced compared with the conventional dielectric duplexer while keeping the similar characteristic.

In the present embodiment, the dielectric filter part 29a for transmission and the dielectric filter part 29b for reception are formed of each of dielectric resonators 12a1,12a2, but a dielectric duplexer of a plurality of stages may be formed using a plurality of dielectric resonators. A thin film multilayer electrode may be used for the electrode.

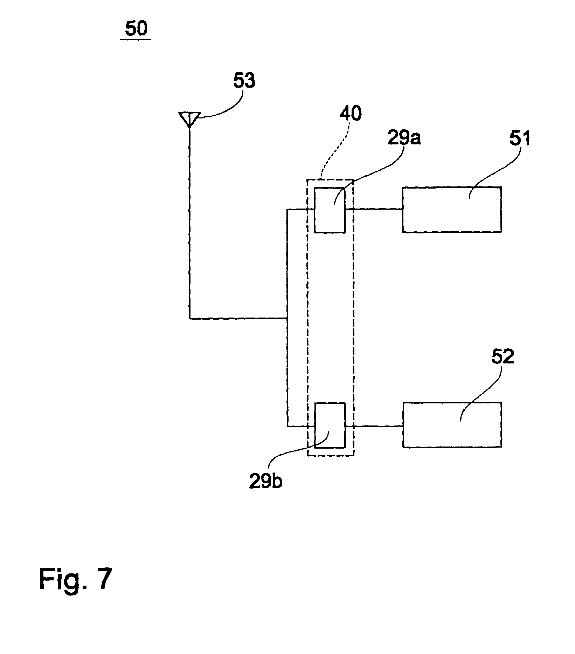

Still further, a communication device which is a fifth embodiment of the present invention is described referring to FIG. 7. FIG. 7 is a schematic diagram of the communication device of the present embodiment.

As illustrated in FIG. 7, a communication device 50 of the present embodiment comprises a dielectric duplexer 40, a transmission circuit 51, a reception circuit 52, and an antenna 53. The dielectric duplexer 40 is same as that illustrated in the above-mentioned embodiment, an external connector 14a to be connected to the first dielectric filter part 29a in FIG. 6 is connected to the transmission circuit 51, and an external connector 14b to be connected to the second dielectric filter part 29b is connected to the reception circuit 52. An external connector 14c is connected to the antenna 53.

In such a construction, the communication device in which the non loaded Q can be improved if the shape is same, or the height or the area can be reduced if the non loaded Q is same, can be provided.

In the present invention, the actual current hardly flows in the shield cavity in which the dielectric resonator is stored. Thus, the loss generated in the conventional part is eliminated, and the non loaded Q is improved. As a result, the height of the band elimination dielectric filter, the dielectric duplexer and the communication device can be reduced compared with the conventional structure if the non loaded Q is same.

Further, in the two-stage band elimination dielectric filter and the dielectric duplexer of the present invention, the resonance frequency can be regulated by the area at the section parallel to the electrode of the dielectric resonator, and the non loaded Q can be regulated mainly by the height of the dielectric resonator, and both the resonance frequency and the non loaded Q can be individually regulated. As a result, the degree of freedom of the design in the shape of the dielectric resonator is increased, the labor of fine regulation during the manufacture is reduced, and the band elimination dielectric filter and the dielectric duplexer having the desired characteristic can be easily provided. In addition, fine regulation has been conventionally required so that dielectric columns crossing each other of the TM double mode dielectric resonator are not coupled, but in the two-stage band elimination dielectric filter of the present invention, two dielectric resonators are separated from each other, and can be individually regulated, and fine regulation becomes unnecessary.

Further, the loss at the electrodes can be reduced compared with a single-layered electrode by forming the electrodes formed on two surfaces opposite to each other of the dielectric resonator of a thin film multilayer electrode. Thus, the non loaded Q is improved, and the band elimination dielectric filter, the dielectric duplexer, and the communication device in which the height is further reduced if the non loaded Q is same, and the non loaded Q is further improved, can be manufactured.

## Claims

1. A band elimination dielectric filter (10; 20; 30) comprising:
a conductive shield cavity (11; 21; 31);
a dielectric resonator (12a; 12b) being arranged in said shield cavity (11; 21);
electrodes (18; 28) formed on the opposite surfaces of said dielectric resonator (12a); and
a conductive external coupling element (13) being coupled with said dielectric resonator (12a) wherein the conductive shield cavity (11; 21; 31) and the dielectric resonator (12a; 12b) are arranged to provide a space between one of the surfaces of the dielectric resonator (12a; 12b) on which the electrodes are formed and an opposing surface of the conductive shield cavity (11; 21; 31); and wherein the conductive external coupling element (13) has an end extending into the space provided between the surface of the dielectric resonator (12a; 12b) and the opposing surface of the conductive shield cavity (11; 21; 31).

2. A band elimination dielectric filter according to claim 1, wherein a plurality of dielectric resonators (12a, 12b) is continuously arranged in said shield cavity (11).

3. A band elimination dielectric filter according to claim 1, wherein dielectric resonators (12a, 12b) of the plurality of dielectric resonators are put on top of each other in said shield cavity.

4. A band elimination dielectric filter according to claim 1, wherein at least one of said electrodes (28) formed on two surfaces opposite to each other of said dielectric resonator (12b) is formed of a thin film multilayer electrode.

5. A dielectric duplexer (40) comprising:
at least two dielectric filters (12a1, 12a2);
a means (14a, 14b) for input/output connection to be connected to each of said dielectric filters (12a1, 12a2), and
a means (14c) for antenna connection to be commonly connected to said dielectric filters (12a1, 12a2),
wherein, at least one of said dielectric filters is the band elimination dielectric filter (10; 20; 30) according to one of Claims 1 through 4.

6. A communication device (50) comprising:
a dielectric duplexer (40) according to claim 5;
a circuit (51) for transmission to be connected to at least one means (14a, 14b) for input/output connection of said dielectric duplexer (40);
a circuit (52) for reception to be connected to at least one means (14a, 14b) for input/output connection different from said means for input/output connection to be connected to said circuit (51) for transmission; and
an antenna (53) to be connected to a means (14c) for antenna connection of said dielectric duplexer (40).

## Patentansprüche

1. Ein dielektrisches Bandbeseitigungsfilter (10; 20; 30), das folgende Merkmale aufweist:
einen leitfähigen Abschirmungshohlraum (11; 21; 31);
einen dielektrischen Resonator (12a; 12b), der in dem Abschirmungshohlraum (11; 21) angeordnet ist;
Elektroden (18; 28), die an den gegenüberliegenden Oberflächen des dielektrischen Resonators (12a) gebildet sind; und
ein leitfähiges externes Kopplungselement (13), das mit dem dielektrischen Resonator (12a) gekoppelt ist, wobei der leitfähige Abschirmungshohlraum (11; 21; 31) und der dielektrische Resonator (12a; 12b) angeordnet sind, um einen Raum zwischen einer der Oberflächen des dielektrischen Resonators (12a; 12b), an der die Elektroden gebildet sind, und einer gegenüberliegenden Oberfläche des leitfähigen Abschirmungshohlraums (11; 21; 31) zu liefern; und wobei das leitfähige externe Kopplungselement (13) ein Ende aufweist, das sich in den Raum erstreckt, der zwischen der Oberfläche des dielektrischen Resonators (12a; 12b) und der gegenüberliegenden Oberfläche des leitfähigen Abschirmungshohlraums (11; 21; 31) bereitgestellt ist.

2. Ein dielektrisches Bandbeseitigungsfilter gemäß Anspruch 1, bei dem eine Mehrzahl von dielektrischen Resonatoren (12a, 12b) durchgehend in dem Abschirmungshohlraum (11) angeordnet ist.

3. Ein dielektrisches Bandbeseitigungsfilter gemäß Anspruch 1, bei dem dielektrische Resonatoren (12a, 12b) der Mehrzahl von dielektrischen Resonatoren in dem Abschirmungshohlraum aufeinander gesetzt sind.

4. Ein dielektrisches Bandbeseitigungsfilter gemäß Anspruch 1, bei dem zumindest eine der Elektroden (28), die an zwei einander gegenüberliegenden Oberflächen des dielektrischen Resonators (12b) gebildet sind, aus einer Dünnfilmmehrschichtelektrode gebildet ist.

5. Ein dielektrischer Duplexer (40), der folgende Merkmale aufweist:
zumindest zwei dielektrische Filter (12a1, 12a2);
eine Einrichtung (14a, 14b) zur Eingangs-/Ausgangs-Verbindung, die mit jedem der dielektrischen Filter (12a1, 12a2) zu verbinden ist, und
eine Einrichtung (14c) zur Antennenverbindung, die gemeinsam mit den dielektrischen Filtern (12a1, 12a2) zu verbinden ist,
wobei zumindest eines der dielektrischen Filter das dielektrische Bandbeseitigungsfilter (10; 20; 30) gemäß einem der Ansprüche 1 bis 4 ist.

6. Eine Kommunikationsvorrichtung (50), die folgende Merkmale aufweist:
einen dielektrischen Duplexer (40) gemäß Anspruch 5;
eine Schaltung (51) zum Senden, die mit zumindest einer Einrichtung (14a, 14b) zur Eingangs-/Ausgangs-Verbindung des dielektrischen Duplexers (40) zu verbinden ist;
eine Schaltung (52) zum Empfang, die mit zumindest einer Einrichtung (14a, 14b) zur Eingangs-/Ausgangs-Verbindung zu verbinden ist, die sich von der Einrichtung zur Eingangs-/Ausgangs-Verbindung unterscheidet, die mit der Schaltung (51) zum Senden zu verbinden ist; und
eine Antenne (53), die mit einer Einrichtung (14c) zur Antennenverbindung des dielektrischen Duplexers (40) zu verbinden ist.

## Revendications

1. Filtre diélectrique d'élimination de bande (10 ; 20 ; 30) comprenant :
une cavité de blindage conductrice (11 ; 21 ; 31) ;
un résonateur diélectrique (12a ; 12b) qui est agencé dans ladite cavité de blindage (11 ; 21) ;
des électrodes (18 ; 28) qui sont formées sur les surfaces opposées dudit résonateur diélectrique (12a) ; et
un élément de couplage externe conducteur (13) qui est couplé avec ledit résonateur diélectrique (12a), dans lequel la cavité de blindage conductrice (11 ; 21 ; 31) et le résonateur diélectrique (12a ; 12b) sont agencés de manière à ménager un espace entre l'une des surfaces du résonateur diélectrique (12a ; 12b) sur laquelle les électrodes sont formées et une surface opposée de la cavité de blindage conductrice (11 ; 21 ; 31) ; et dans lequel l'élément de couplage externe conducteur (13) comporte une extrémité qui s'étend à l'intérieur de l'espace qui est ménagé entre la surface du résonateur diélectrique (12a ; 12b) et la surface opposée de la cavité de blindage conductrice (11 ; 21 ; 31).

2. Filtre diélectrique d'élimination de bande selon la revendication 1, dans lequel une pluralité de résonateurs diélectriques (12a, 12b) sont agencés en continu dans ladite cavité de blindage (11).

3. Filtre diélectrique d'élimination de bande selon la revendication 1, dans lequel des résonateurs diélectriques (12a, 12b) de la pluralité de résonateurs diélectriques sont placés sur le sommet les uns des autres dans ladite cavité de blindage.

4. Filtre diélectrique d'élimination de bande selon la revendication 1, dans lequel au moins l'une desdites électrodes (28) qui sont formées sur deux surfaces opposées l'une à l'autre dudit résonateur diélectrique (12b) est formée par une électrode multicouche en film mince.

5. Duplexeur diélectrique (40) comprenant :
au moins deux filtres diélectriques (12a1, 12a2) ;
un moyen (14a, 14b) de connexion d'entrée/sortie destiné à être connecté sur chacun desdits filtres diélectriques (12a1, 12a2) ; et
un moyen (14c) de connexion d'antenne destiné à être connecté de façon commune auxdits filtres diélectriques (12a1, 12a2),
dans lequel au moins l'un desdits filtres diélectriques est le filtre diélectrique d'élimination de bande (10 ; 20 ; 30) selon l'une des revendications 1 à 4.

6. Dispositif de communication (50) comprenant :
un duplexeur diélectrique (40) selon la revendication 5 ;
un circuit (51) d'émission destiné à être connecté sur au moins un moyen (14a, 14b) de connexion d'entrée/sortie dudit duplexeur diélectrique (40) ;
un circuit (52) de réception destiné à être connecté sur au moins un moyen (14a, 14b) de connexion d'entrée/sortie qui est différent dudit moyen de connexion d'entrée/sortie destiné à être connecté sur ledit circuit (51) d'émission ; et
une antenne (53) destinée à être connectée sur un moyen (14c) de connexion d'antenne dudit duplexeur diélectrique (40).
